# EUROPEAN PATENT APPLICATION

(11) **EP 4 592 637 A1**
(43) Date of publication of application: **30.07.2025**
(21) Application number: 24154468.3
(22) Date of filing: 29.01.2024
(51) Int. Cl.: G01B 9/02, G01B 11/24, G03H 1/04, G03H 1/08

(54) **METHOD FOR DETERMINING A SURFACE MAP AND IMAGING SYSTEM FOR SAME**

(71) Applicant: Mitutoyo Corporation, Kawasaki-shi, Kanagawa 213-8533 (JP)
(72) Inventor: MUKUNDAKUMAR, Balasubrahmaniyam, 5627 AC Einhoven (NL); MATSUURA, Shimpei, 5658 LL Einhoven (NL)
(74) Representative: EP&C

(57) **Abstract**

The invention relates to a method for determining a surface map, such as a height map, of a sample surface having a first region with a first reflectivity and a second region with a different reflectivity, wherein use is made of an imaging system for determining an image of the sample surface, wherein the imaging system has a focal measurement plane. The method comprises determining that an image of the sample surface obtained with the imaging system is saturated when the sample surface is arranged in the focal measurement plane of the imaging system; arranging the sample surface in a defocused position at a distance Z from the focal measurement plane of the imaging system along an axis perpendicular to the focal measurement plane such that the image of the sample surface obtained with the imaging system is no longer saturated; obtaining a defocused image of the sample surface arranged in the defocused position with the imaging system; determining an infocus image by backpropagating the defocused image the distance Z by applying a backpropagation algorithm to the defocused image; and determining the surface map of the sample surface based on the infocus image. The invention further relates to an imaging system for determining a surface map of a sample surface having a first region with a first reflectivity and a second region having a second reflectivity. The invention is further related to a digital data carrier comprising a computer program which, when run on a processor of an imaging system according to the invention, causes the imaging system to perform the method according to the invention.

## Description

The invention relates to a method for determining a surface map, such as a height map, of a sample surface having a first region with a first reflectivity and a second region with a second reflectivity. The invention further relates to an imaging system for determining a surface map of a sample surface having a first region with a first reflectivity and a second region having a second reflectivity. The invention is further related to a digital data carrier comprising a computer program which, when run on a processor of an imaging system according to the invention, causes the imaging system to perform the method according to the invention.

Determining a surface map of sample surface may be required for example for inspection at different stages of manufacturing of the sample. For example, the sample may be a semiconductor, where it may be important to monitor development of structures thereon. In the semiconductor industry, inline structural examination of surface structures made of silicon and noble metals may be important for different stages of lithography and metal bonding.

Generally, the sample surface may be illuminated, e.g. using a dedicated light source in an interferometer or using background light, which light may be reflected by the sample surface and captured by an imaging system. The imaging system generally has a limited dynamic range such that samples reflecting too much or too little light may not be effectively measured. In order to prevent an image of the sample surface taken by the imaging system to be saturated, e.g. too much light has fallen onto the imaging system, e.g. an optical sensor thereof, an intensity of light projected on the sample surface may be reduced. Equivalently, an overall integration time of the imaging system may be reduced. A downside of this approach is that, when a sample surface has regions of differing reflectivities, regions having lower reflectivities may not reflect enough light to allow a proper measurement thereof. Thus, either some regions, e.g. corresponding to regions of the sample surface having a higher reflectivity, of the image may be saturated, e.g. when an overall light intensity is higher, or some regions, e.g. corresponding to regions of the sample surface having a lower reflectivity, of the image may be too dark. In other words, using the known approach either some parts, e.g. pixels, of the imaging system receive too much light or too little light depending on the measurement parameters and taking a reliable image of a field of view of the imaging system may not be possible.

The invention aims to provide a method for determining a surface map of a sample surface with an increased effective dynamic range, i.e. such that sample surfaces having a wider range of reflectivities may still be properly determined by an imaging system.

The aim of the invention is achieved by the method according to claim 1.

Th method is a method for determining a surface map of a sample surface. For example, the surface map may be a height map of the sample surface. For example, the height map may be based on a phase map of the sample surface. The sample may be a semiconductor, e.g. in a manufacturing process.

The sample surface has a first region with a first reflectivity and a second region with a second reflectivity. The first reflectivity differs from the second reflectivity. In examples, the sample surface may have a plurality of regions having different reflectivities. For example, the first region is a region having a lowest reflectivity and the second region is a region having a highest reflectivity. For example, a reflectivity difference between the first region and second region may be a highest reflectivity difference between regions of the sample surface. The different reflectivities may be a result of material differences between the regions or different orientations, e.g. slopes, of the surface relative to the imaging system.

The method makes use of an imaging system for determining, or measuring, an image of the sample surface. The imaging system has a focal measurement plane. The image of the sample surfaces may comprise pixels of the imaging system, which pixel values after measuring a light reflected of the sample surface allows to determine the surface map. The imaging system may be an interferometer, e.g. such as a digital holography interferometer, or other type of suitable imaging system. The focal measurement plane may be perpendicular to an optical axis of the imaging system. The focal measurement plane may be determined to be a plane wherein an object is in focus of the imaging system.

The method comprises determining that an image of a sample surface obtained by the imaging system is saturated when the sample surface is arranged in the focal measurement plane of the imaging system, e.g. the sample surface is in focus of the imaging system. For example, an image of the sample surface may be taken with the imaging system, e.g. using measurement parameters such as light intensity and integration time of the imaging system, and it may be observed or determined that one or more pixels of the imaging system are saturated. The sample surface may be arranged substantially aligned with and substantially at the focal measurement plane. Determining that an image of the sample surface obtained with the imaging system is saturated may be performed in various ways. For example, the determining may be based on a light intensity measurement of light reflected of the sample surface using a presensor, i.e. no image of the sample surface may be taken using the imaging system. An image of the sample surface may be taken and an explicit determining of a saturation may be performed, e.g. using a computer program or a human observer.

In response to the determining that an image of the sample surface obtained with the imaging system is saturated when the sample surface is arranged in the focal measurement plane of the imaging system, the sample surface is arranged in a defocused position at a distance Z from the focal measurement plane of the imaging system along an axis perpendicular to the focal measurement plane such that the image of the sample surface obtained with the imaging system is no longer saturated. By arranging the sample surface in the defocused position, the image obtained with the imaging system may be out of focus. As a result, an image obtained with the imaging system with the sample surface out of focus is blurry, such that the lighter and darker regions mix. This results in a relative increase in light intensity in darker regions of the image and a relative decrease in light intensity if lighter regions of the image, dependent on the distance Z that the sample surface is arranged out of focus. By providing the sample surface further from the focal measurement plane, more mixing between the lighter and darker regions may occur and lightest regions, i.e. regions having a higher reflectivity, may appear darker in the defocused image. By moving the sample surface sufficiently out of focus, the image may no longer be saturated as saturated regions may have mixed sufficiently with darker regions.

The distance Z may be determined by progressively moving the image further from the focal measurement plane and observing an effect on the saturation of the obtained image or a reflected light intensity determined using a presensor. The distance Z may also be determined using calculations, e.g. depending on a reflectivity of the sample surface and a light intensity.

The imaging system may comprise a sample holder which is movable relative to the focal measurement plane such that the sample surface may be arranged at a desired distance Z by moving the sample holder.

The method comprises obtaining a defocused image of the sample surface with the imaging system when the sample surface is arranged in the defocused position, e.g. at the desired distance Z from the focal measurement plane. The defocused image may comprise information on amplitude and phase of light reflected of the sample surface, e.g. for each pixel of the imaging system. The defocused image may be obtained by the imaging system and subsequently provided to a processor for further processing according to embodiments disclosed herein.

Based on the defocused image, an infocus image is determined by backpropagating the defocused image the distance Z by applying a backpropagatio0n algorithm to the defocused image. For example, the backpropagation algorithm may use a defocused phase and defocused amplitude of each pixel of the defocused image to determine an infocus phase and/or amplitude for the infocus image. The distance Z may be an explicit input into the backpropagation algorithm. As a result, the infocus image may have pixel values that are outside of the dynamic range of the imaging system. Thus, this method allows to determine an image of the sample surface having an effective dynamic range greater than the dynamic range of the imaging system. For example, the backpropagation algorithm may be a numerical propagation algorithm such as an angular spectrum algorithm or a Fresnel propagation algorithm.

This allows to determine the surface map of the sample surface having different reflectivities, wherein otherwise at least some regions of the image would be saturated or too dark. For example, the surface map may be a height map of the sample surface, e.g. based on on infocus phase of the sample surface. The surface map may also be represented by the infocus image directly.

In embodiments of the method, the imaging system is configured for determining a phase and an amplitude of the image of the sample surface, wherein the obtaining the defocused image comprises determining a defocused phase and a defocused amplitude of the defocused image, and wherein the backpropagation algorithm is based on the determined defocused phase and a determined defocused amplitude of the defocused image. For example, the defocused phase and/or amplitude may be determined based on a carrier fringe method, a phase shifting method, a heterodyning method, or a Lissajous phase extraction based method.

In embodiments, the imaging system is an interferometer comprising a light source and wherein the defocused image is a defocused interferogram, wherein the infocus image is an infocus interferogram, and wherein the surface map is a height map, e.g. based on a phase map of the sample surface. For example, the interferometer may comprise:
- a light source for emitting a light beam;
- a beamsplitter for splitting the light beam into a reference light beam propagating along a reference path and a sample light beam propagating along a sample path;
- an optical sensor with a focal measurement plane;
- a reference mirror for reflecting the reference light beam towards the imaging system;
- a sample holder for holding the sample, wherein the sample holder is movable relative to the optical sensor in a direction parallel to the sample path, e.g. wherein the sample holder comprises means to move the sample holder relative to the imaging system in the direction parallel to the sample path; and
- a processor connected to the imaging system.

In further embodiments, the method further comprises:
- determining an average intensity of a sample light beam reflected of the sample surface; and
- providing a reference surface such that an average intensity of a reflected reference light beam is equal to the average intensity of the reflected sample light beam.

In further embodiments, the interferometer is a digital holography interferometer.

In embodiments, the distance Z is in dependence of a reflectivity difference between the first reflectivity and the second reflectivity, e.g. such that such that the distance Z is larger for a larger reflectivity difference and smaller for a smaller reflectivity difference. The distance Z may be larger for a larger reflectivity difference and smaller for a smaller reflectivity distance if other relevant parameters, e.g. such as incident light intensity, reflective region size and imaging system properties, are the same or similar. As a result, the distance Z may be determined by determining the reflectivity difference between the first and second regions and, for example based on a single image of the sample surface taken by the imaging system.

In embodiments, the distance Z is in dependence of a dynamic range of the imaging system such that the distance Z is larger if the dynamic range is smaller and such that the distance Z is smaller if the dynamic rage is larger. For example, the distance Z in these embodiments may be determined based on a dynamic range of the imaging system. For example, an approximate distance Z may be determined based on the dynamic range of the imaging system and, for example, other parameters such as the reflectivity difference and incident light intensity.

In embodiments, the distance Z is such that a difference between a highest intensity of the defocused image and a lowest intensity of the defocused image is below a predetermined intensity threshold, e.g. for a predetermined light beam intensity. For example, the predetermined intensity threshold may depend on a dynamic range of the imaging system.

In embodiments, the backpropagation algorithm is one of an angular spectrum algorithm and a Fresnel propagation algorithm.

In embodiments, the surface map is determined from the infocus image using one of a carrier fringe method, a phase shifting method, a heterodyne method and Lissajous phase extraction method.

The invention further relates to an imaging system for determining a surface map of a sample surface having a first region with a first reflectivity and a second region with a second reflectivity, wherein the imaging system comprises a processor, and wherein the imaging system is configured for determining an image of the sample surface, wherein the imaging system has a focal measurement plane, wherein the imaging system, e.g. the processor thereof, is configured for:
- determining that an image of the sample surface obtained with the imaging system is saturated when the sample surface is arranged in the focal measurement plane of the imaging system;
- arranging, e.g. using a movable sample holder, the sample surface in a defocused position at a distance Z from the focal measurement plane of the imaging system along an axis perpendicular to the focal measurement plane such that the image of the sample surface obtained with the imaging system is no longer saturated;
- obtaining a defocused image of the sample surface arranged in the defocused position;
- determining an infocus image by backpropagating the defocused image the distance Z by applying a backpropagation algorithm to the defocused image; and
- determining the surface map of the sample surface based on the infocus image.

The imaging system of the invention may be used to perform the method of the invention. The imaging system allows to increase the effective dynamic range thereof, e.g. of an optical sensor thereof, by performing a measurement of the sample surface at the distance Z and using a backpropagation algorithm to obtain an infocus image.

In embodiments of the imaging system, the imaging system, e.g. the processor thereof, is configured for determining a phase and an amplitude of the image of the sample surface and wherein the backpropagation algorithm is based on a defocused phase and a defocused amplitude of the defocused image.

In embodiments of the imaging system, the imaging system is an interferometer, e.g. an digital holography interferometer, e.g. an interferometer as described herein, comprising a light source and wherein the defocused image is a defocused interferogram, wherein the infocus image is an infocus interferogram, and wherein the surface map is a height map.

The invention further relates to a digital data carrier comprising a computer program which, when run on a processor of an imaging system according to the invention, causes the imaging system to perform the method according to the invention.

Embodiments of the invention will now be described, by way of example, with reference to the accompanying drawing in which corresponding reference symbols indicate corresponding parts, and in which:
- Fig. 1 shows an imaging system; and
- Fig. 2 shows a flowchart of a method for determining a surface map.

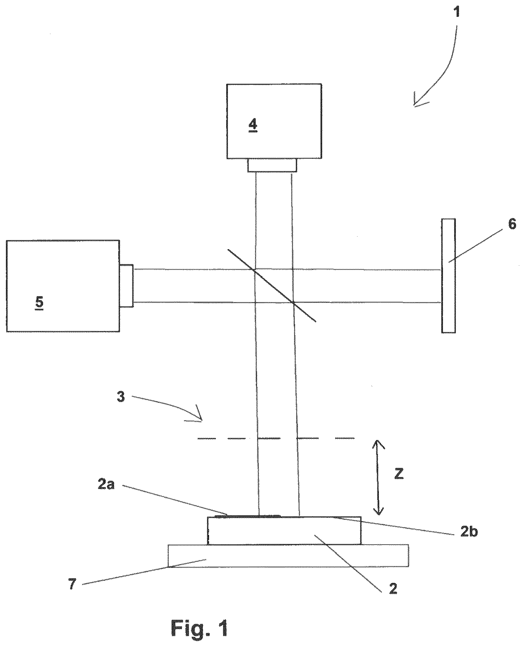

Figure 1 shows an imaging system 1 embodied as an interferometer comprising a light source 4, an optical sensor 5 and a reference surface 6. The imaging system 1 further comprises a moveable sample holder 7 for holding a sample 2 and for allowing movement of the sample 2 relative to the focal measurement plane 3 in a direction perpendicular to the focal measurement plane 3.

In figure 1, the sample surface is at a distance Z from the focal measurement plane 3, such that a defocused image taken with the optical sensor 5 from the sample surface is not saturated, even though if the sample surface would be in the focal measurement plane 3 the image would be saturated.

The sample 2 has a first region 2a having a first reflectivity and a second region 2b having a second reflectivity. The difference in reflectivity may be such that an incident light from the light source 4 reflected of the first region 2a would saturate the optical sensor 5, whereas at the same time the incident light reflected of the second region 2b would be too little to allow for proper determining of the surface map of the sample surface.

The imaging system 1 comprises an optical sensor 4 which emits a light beam which is split by a beamsplitter into a reference light beam which reflects of the reference surface 6 to the optical sensor 5 and a sample light beam which reflects of the sample 2 to the optical sensor 5. The two light beams interfere producing interferograms which allow to determine a phase and/or amplitude of light reflected of the sample 2.

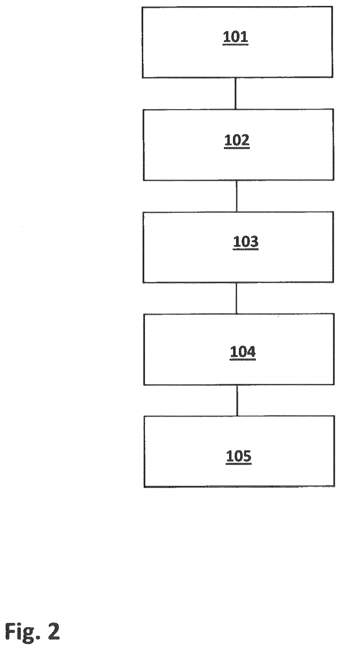

The imaging system is configured to perform the method of the invention shown in figure 2:
- determining 101 that an image of the sample surface obtained with the imaging system is saturated when the sample surface is arranged in the focal measurement plane of the imaging system;
- arranging 102 the sample surface in a defocused position at a distance Z from the focal measurement plane of the imaging system along an axis perpendicular to the focal measurement plane such that the image of the sample surface obtained with the imaging system is no longer saturated;
- obtaining 103 a defocused image of the sample surface arranged in the defocused position with the imaging system;
- determining 104 an infocus image by backpropagating the defocused image the distance Z by applying a backpropagation algorithm to the defocused image; and
- determining 105 the surface map of the sample surface based on the infocus image.

As explained above, the invention allows to determine a surface map of the sample 2 having a first region 2a and a second region 2b with different reflectivities in cases where using known methods the surface map would be compromised either by a saturated image of the sample 2 or too little light collected by the imaging system 1. This is done by placing the sample 2 a distance Z from the focal measurement plane 3 of the imaging system 1, such that a resulting defocused image of the sample 2 is not saturated because ligther regions may mix with darker regions of the sample 2. By subsequently applying a backpropagation algorithm on the defocused image, an infocus image of the sample 2 may be determined which infocus image may have regions lying outside of the dynamic range of the imaging system 1.

In embodiments, an average intensity of the sample light beam reflected by the sample 2 may be determined and the reference surface 6 may be provided, e.g. a mirror having a desired reflectivity, such that the average intensity of the reference light beam is substantially equal to the average intensity of the reflected sample light beam.

The distance Z of the sample 2 from the focal measurement plane 3 may depend on one or more of a light intensity emitted by the light source 4, a reflectivity of the first region 2a, a reflectivity of the second region 2b, a reflectivity difference between the first and second regions 2a, 2b, and a dynamic range of the imaging system 1. The sample surface is arranged at the distance Z such that, e.g. in dependence of one or more of the above mentioned parameters, a defocused image is not saturated. This allows to backpropagate the defocused image to an infocus image, e.g. outside of the dynamic range of the imaging system 1, such that it may be said that the effective dynamic range of the imaging system 1 is increased.

## Claims

1. Method for determining a surface map of a sample surface having a first region with a first reflectivity and a second region with a second reflectivity, wherein the first reflectivity is different from the second reflectivity, wherein use is made of an imaging system for determining an image of the sample surface, wherein the imaging system has a focal measurement plane, wherein the method comprises:
- determining that an image of the sample surface obtained with the imaging system is saturated when the sample surface is arranged in the focal measurement plane of the imaging system;
- arranging the sample surface in a defocused position at a distance Z from the focal measurement plane of the imaging system along an axis perpendicular to the focal measurement plane such that the image of the sample surface obtained with the imaging system is no longer saturated;
- obtaining a defocused image of the sample surface arranged in the defocused position with the imaging system;
- determining an infocus image by backpropagating the defocused image the distance Z by applying a backpropagation algorithm to the defocused image; and
- determining the surface map of the sample surface based on the infocus image.

2. Method according to claim 1, wherein the imaging system is configured for determining a phase and an amplitude of the image of the sample surface, wherein the obtaining the defocused image comprises determining a defocused phase and a defocused amplitude of the defocused image, and wherein the backpropagation algorithm is based on the determined defocused phase and a determined defocused amplitude of the defocused image.

3. Method according to one or more of the preceding claims, wherein the imaging system is an interferometer comprising a light source and wherein the defocused image is a defocused interferogram, wherein the infocus image is an infocus interferogram, and wherein the surface map is a height map, e.g. based on a phase map of the sample surface.

4. Method according to claim 3, wherein the method further comprises:
- determining an average intensity of a sample light beam reflected of the sample surface; and
- providing a reference surface such that an average intensity of a reflected reference light beam is equal to the average intensity of the reflected sample light beam.

5. Method according to one or more of the claims 3-4, wherein the interferometer is a digital holography interferometer.

6. Method according to one or more of the preceding claims, wherein the distance Z is in dependence of a reflectivity difference between the first reflectivity and the second reflectivity, e.g. such that such that the distance Z is larger for a larger reflectivity difference and smaller for a smaller reflectivity difference

7. Method according to one or more of the preceding claims, wherein the distance Z is in dependence of a dynamic range of the imaging system such that the distance Z is larger if the dynamic range is smaller and such that the distance Z is smaller if the dynamic rage is larger.

8. Method according to one or more of the preceding claims, wherein the distance Z is such that a difference between a highest intensity of the defocused image and a lowest intensity of the defocused image is below a predetermined intensity threshold, e.g. for a predetermined light beam intensity.

9. Method according to one or more of the preceding claims, wherein the backpropagation algorithm is one of an angular spectrum algorithm and a Fresnel propagation algorithm.

10. Method according to one or more of the preceding claims, wherein the surface map is determined from the infocus image using one of a carrier fringe method, a phase shifting method, a heterodyne method and Lissajous phase extraction method.

11. Imaging system for determining a surface map of a sample surface having a first region with a first reflectivity and a second region with a second reflectivity, wherein the imaging system comprises a processor, and wherein the imaging system is configured for determining an image of the sample surface, wherein the imaging system has a focal measurement plane, wherein the imaging system, e.g. the processor thereof, is configured for:
- determining that an image of the sample surface obtained with the imaging system is saturated when the sample surface is arranged in the focal measurement plane of the imaging system;
- arranging, e.g. using a movable sample holder, the sample surface in a defocused position at a distance Z from the focal measurement plane of the imaging system along an axis perpendicular to the focal measurement plane such that the image of the sample surface obtained with the imaging system is no longer saturated;
- obtaining a defocused image of the sample surface arranged in the defocused position;
- determining an infocus image by backpropagating the defocused image the distance Z by applying a backpropagation algorithm to the defocused image; and
- determining the surface map of the sample surface based on the infocus image.

12. Imaging system according to claim 11, wherein the imaging system, e.g. the processor thereof, is configured for determining a phase and an amplitude of the image of the sample surface and wherein the backpropagation algorithm is based on a defocused phase and a defocused amplitude of the defocused image.

13. Imaging system according to one or more of the claims 11 - 12, wherein the imaging system is an interferometer, e.g. an digital holography interferometer, comprising a light source and wherein the defocused image is a defocused interferogram, wherein the infocus image is an infocus interferogram, and wherein the surface map is a height map.

14. Digital data carrier comprising a computer program which, when run on a processor of an imaging system according to one or more of the claims 9 - 13, causes the imaging system to perform the method according to one or more of the claims 1-8.
